(19) Europäisches Patentamt
European Patent Office
Office européen des brevets

(11) **EP 1 698 905 B1**

(12) **EUROPEAN PATENT SPECIFICATION**

(45) Date of publication and mention
of the grant of the patent:
**20.07.2011 Bulletin 2011/29**

(51) Int Cl.:
***G01R 1/073*** *(2006.01)*      ***G01R 3/00*** *(2006.01)*

(21) Application number: **06009611.2**

(22) Date of filing: **15.09.1999**

(54) **Nano-drive for high resolution positioning and for positioning of a multi-point probe**

Nanoantrieb für hochauflösende Positionierung und zur Positionierung einer Mehrpunktsonde

Nano-actionneur pour le positionnement de haute résolution et pour le positionnement d'une sonde à points multiples

(84) Designated Contracting States:
**AT BE CH CY DE DK ES FI FR GB GR IE IT LI LU MC NL PT SE**

(43) Date of publication of application:
**06.09.2006 Bulletin 2006/36**

(62) Document number(s) of the earlier application(s) in accordance with Art. 76 EPC:
**99610052.5 / 1 085 327**

(73) Proprietor: **Capres A/S**
**2800 Lyngby (DK)**

(72) Inventors:
• **Petersen, Christian Leth**
**Burnaby**
**BC V5C 3Y1 (CA)**

• **Nielsen, Peter Folmer**
**3250 Farum (DK)**
• **Bøggild, Peter**
**2000 Copenhagen N (DK)**
• **Quaade, Ulrich**
**2880 Bagsværd (DK)**
• **Grey, Francois**
**01170 Echenevex (FR)**

(74) Representative: **Nielsen, Henrik Sten**
**Budde Schou A/S**
**Vester Søgade 10**
**1601 Copenhagen V (DK)**

(56) References cited:
**EP-A- 0 802 419      WO-A-97/21105**
**JP-A- 6 224 449      JP-A- 8 015 318**
**US-A- 5 172 050      US-A- 5 347 226**
**US-A- 5 475 318**

## Description

### Field of the invention

The present invention generally relates to a multi-point probe and further relates to the technique of testing electric properties on a specific location of a test sample and in particular the technique of probing and analysing semiconductor integrated circuits for example of LSI and VLSI complexity.

### Description of the related art

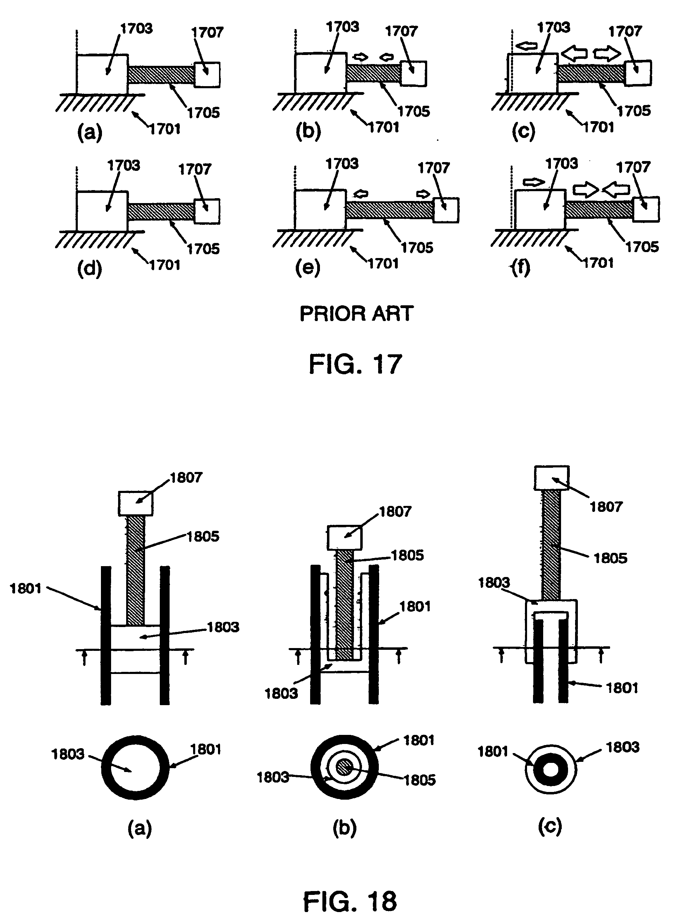

A method for creating very small movements by means of inertial force is known from the literature, for example US pat. 5229679. This method will now be described referring to fig. 17.

An apparatus for creating very small movements according to prior art, comprises a support 1701, a movable part 1703, a piezoelectric element 1705 and an inertial part 1707. The movable part 1703 is held against the support 1701 by means of gravitation or a spring-load. The piezoelectric element can be contracted or elongated by applying an electrical field to the element. If the contraction or elongation occur slowly, the frictional force between the support and the movable part will prevent any movement of the movable part. However, when the electrical field on the movable part changes in such a way that the piezoelectric element contract or elongates quickly, the force on the movable part can exceed the frictional force between the movable part and the substrate, causing the movable part to change its position relative to the substrate with a fraction of a micrometer. In this way a slow contraction followed by a quick elongation will cause the movable part to change position. This is shown in figure 17a-c. By repeated slow contraction and quick elongation of the element, the movable part can travel over several millimeters. The movable part can be made to travel in the opposite direction by repeated quick contraction and slow elongation of the piezoelectric element as shown in figure 17d-f.

In the prior art, only the change in length of the piezoelectric element in the direction of movement is used to create the movement of the movable part. The time dependence of the electrical field on the piezoelectric element for providing the movement is described in the literature as a sawtooth curve-form (for example US Pat. 5568004).

In the prior art, all realizations of the known motion principle use the moving part 1703 to move a body fixed to said part relative to another body which is fixed to the underlying support 1701. Furthermore, in all existing realizations of the known motion principle the frictional forces are induced by outer forces such as gravitational forces, electro-mechanical forces, or external spring-loads in a highly asymmetrical manner.

The most commonly used technique of testing the electric properties of a test sample involves the generation of resistivity or carrier concentration profiles of the surface of a processed semiconductor wafer by the utilisation of a four-point probe as described in published international patent application WO 94/11745. Furthermore, see for example S.M. Sze, Semiconductor devices - Physics and Technology, Wiley New York (1985).

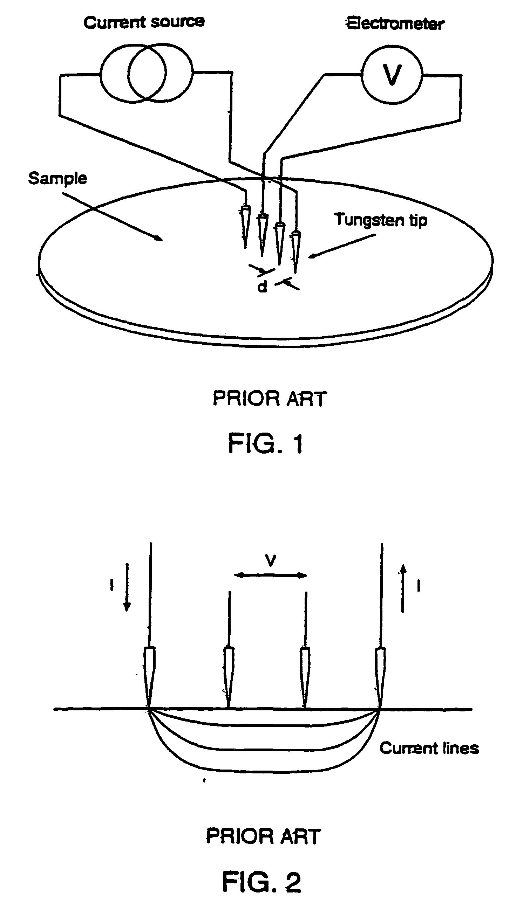

As shown generally in figure 1, the conventional four-point probe technique typically has the points positioned in an in-line configuration. By applying a current to the two peripheral points as shown in detail in figure 2, a voltage can be measured between the two inner points of the four point probe. Thus the electric resistivity of the test sample can be determined through the equation

$$\rho = c \cdot (V/I),$$

wherein V is voltage measured between inner points, wherein I is current applied to the peripheral points and, wherein c is a geometry factor depending on the surface contact separation d and the dimensions of the test sample. Several schemes for calculating the correction factors have been developed, see F.M. Smits, Measurement of Sheet Resistivities with the Four-Point Probe, Bell System Technical J. 37, 711 (1958), EP 0 299 875 B1, and J. Shi and Y. Sun, New method for calculation of the correction factors for the measurement of sheet resistivity of a square sample with a square four-point probe, Rev. Sci. Instrum. 68 1814 (1997).

The four-point probe generally consists of four tungsten or solid tungsten carbide tips positioned into contact with a test sample, being for example a semiconductor wafer. An external positioning system places the four-point probe into physical contact with the semiconductor wafer by moving the four-point probe in a perpendicular motion relative to the wafer surface. Pressure perpendicular to the wafer surface has to be applied to the four-point probe, in order to ensure that all four points obtain physical contact with for example an uneven wafer surface. Hence the pressure from the tips on the surface varies between the tips. The tips are separated by a distance d, shown in figure 1, typically in the order of 0.5 mm.

An alternative to the above described four-point probe is the SR (Spreading Resistance) probe, described in US Patent No. 5,347,226 and hereby incorporated in this description by reference. The SR probe consists of two probe tips situated on one cantilever arm. The SR probe is brought into physical contact with wafer surface by an external positioning system, while monitoring the applied pressure such as to accurately control the physical contact to the uneven surface of a semiconductor wafer. However, since the tips are situated on the same cantilever beam the pressure monitored while monitoring the maximum pressure may possibly leave one tip with an inferior physical contact.

Additionally, reference is made to US Patent No. 5,475,318, US Patent No. 5,540,958, US Patent No. 5,557,214, European patent application EP 0 466 274 and European patent application having application number EP 98610023.8, national German patent application DE 196 48 475 and national Japanese patent applications JP 07199219, JP 01147374 and JP H8-15318, which describe the general technical field relating to methods for measuring resistance and to production of measurement probes. The US patents are hereby incorporated in this description by reference. Furthermore, reference is made to Soonil Hong et al's article regarding design and fabrication of a monolithic high-density probe card for high-frequency on-wafer testing published in IEEE 1989, pg. 289-292, 7th issue, Changyeol Lee et al's article regarding high-density silicon microprobe arrays for LCD pixel inspection published in IEEE 1996, pg. 429-434, 6th issue, T. Fujii et al's article regarding micropattern measurement with an atomic force microscope published in Journal of Vacuum Science & Technology B (Microelectronics Processing and Phenomena) 1991 9th issue, pg. 666, H.W.P. Koops et al's article regarding Constructive three-dimensional lithography with electron beam induced deposition for quantum effect devices published in Journal of Vacuum Science & Technology B (Microelectronics Processing and Phenomena) 1993 11th issue, pg. 2386, H.W. Koops et al's article regarding conductive dots, wires, and supertips for field electron emitters produced by deposition on samples having increased temperature published in Journal of Vacuum Science & Technology B (Microelectronics Processing and Phenomena) 1996 14th issue, pg. 6, and Q. Niu et al's article regarding double tip scanning tunnelling microscope for surface analysis published in Physics Rev. B 1995 51st issue pg. 5502.

Furthermore, apart from the above described limitations as to establishing contact with the surface of the test sample to be tested the prior art probes possess limitations as to miniaturisation of the testing technique as the probes hitherto known limit the maximum spacing between any two tips to a dimension in the order of 0.5 mm due to the production technique involving mechanical positioning and arresting of the individual testing pins or testing tips, in particular as far as the four-point probes are concerned, and as far as the SR-probes are concerned exhibit extreme complexity as far as the overall structure is concerned and also certain drawbacks as far as the utilisation of the SR-probe due to the overall structure of the SR-probe.

An object of the present invention is to provide a novel testing probe allowing the testing of electronic circuits of a smaller dimension as compared to the prior art testing technique and in particular of providing a testing probe allowing a spacing between testing pins less than 0.5 mm such as in the order of 100 nm e.g. 1 nm -1 μm or even smaller spacing.

A particular advantage of the present invention is related to the fact that the novel testing technique involving a novel multi-point probe allows the probe to be utilised for establishing a reliable contact between any testing pin or testing tip and a specific location of the test sample, as the testing probe according to the present invention includes individually bendable or flexible probe arms.

A particular feature of the present invention relates to the fact that the testing probe according to the present invention may be produced in a process compatible with the production of electronic circuits, allowing measurement electronics to be integrated on the testing probe, and allowing for tests to be performed on any device fabricated by any appropriate circuit technology involving planar technique, CMOS technique, thick-film technique or thin-film technique and also LSI and VLSI production techniques.

The above object, the above advantage and the above feature together with numerous other objects, advantages and features which will be evident from the below detailed description of a preferred embodiment of the present invention is according to a first aspect of the present invention obtained by a multi-point testing apparatus for testing electric properties on a specific location of a test sample, comprising:

means for receiving and supporting said test sample;
electric properties testing means (106) including electric generator means for generating a test signal and electric measuring means for detecting a measuring signal;
a multi-point probe, comprising:

a supporting body originating from a wafer body;
a first multitude of conductive probe arms positioned in co-planar relationship with a surface of said supporting body, and freely extending from said supporting body, giving individually flexible motion of said first multitude of conductive probe arms; and
said conducting probe arms originating from a process of producing said multi-point probe including producing said conductive probe arms on said wafer body in facial contact with said wafer body and removal of a part of said wafer body providing said supporting body and providing said conductive probe arms freely extending from said supporting body;
said multi-point probe communicating with said electric properties testing means; and
nano driving means configured for reciprocating said multi-point probe relative said test sample so as to cause said conductive probe arms to be contacted with said specific location of said test sample for performing said testing of electric properties thereof.

According to the basic realisation of the present invention, the multi-point probe according to the first aspect of the present invention is implemented in accordance with the technique of producing electronic circuits, in particular involving planar techniques as the probe is produced from a supporting body, originating from a wafer body on which a first multitude of conductive probe arms are produced involving deposition, accomplished by any technique known in the art, such as chemical vapour deposition (CVD), plasma enhanced CVD (PECVD), electron cyclotron resonance (ECR) or sputtering, etching or any other production technique, for example high resolution lithographic methods such as electron-beam lithography, atomic force microscopy (AFM) lithography or laser lithography, whereupon a part of the original supporting body is removed through mechanical grinding or etching producing the freely extending conducting probe arms characteristic to the present invention constituting the test pins of multi-point probes according to the first aspect of the present invention.

The above part, which is removed from the original wafer body, producing the body supporting the conductive probe arms may constitute a minor part or a major part of the original wafer body and, the supporting body may according to alternative embodiments of the multi-point probe according to the present invention dimensionally constitute a minor part or a major part as compared to the freely extending part of the conductive probe arms.

The conductive probe arms characteristic to the multi-point probe according to the first aspect of the present invention according to the basic realisation of the present invention allow the contacting of the multi-point probe in an angular positioning of the conductive probe arms in relation to the surface of the test sample to be tested as distinct from the above described four-point probe, which is moved perpendicularly in relation to the surface of the test sample. The angular orientation of the conductive probe arms of the multi-point probe allows the flexible and elastically bendable conductive probe arms to contact any specific and intentional location of the test sample and establish a reliable electrical contact with the location in question.

The technique characteristic to the present invention of establishing the contact between the multi-point probe and the test locations of the test sample by utilising an angular positioning of the conductive probe arms in relation to the test sample for contacting in a bending or flexing of the conducting probe arms prevents the probe arms from mechanically destroying or deteriorating the test sample to be tested, which may be of crucial importance in specific applications such as LSI and VLSI circuitry.

As distinct from the prior art four-point probe arm, the multi-point probe according to the present invention including a first multitude of conductive probe arms may be configured in any appropriate configuration due to the utilisation of the production technique, allowing the conducting probe arms to be orientated in any mutual orientation in relation to one another and further in relation to the supporting body for complying with specific requirements such as a specific test sample to be tested. In this context, the particular feature of the present invention, namely the possibility of utilising a production technique compatible with the techniques used for producing electronic circuits, allows the multi-point probe to be readily configured in accordance with specific requirements through the utilisation of existing CAD/CAM techniques for micro-systems. However, according to the presently preferred embodiment of the multi-point probe according to the first aspect of the present invention, the first multitude of conductive probe arms are unidirectional constituting a multitude of parallel free extensions of the supporting body.

The possibility discussed above, of configuring the multi-point probe according to the first aspect of the present invention in accordance with specific requirements and, in particular, specific configurations or geometry of the electronic circuit to be tested constituting the test sample allows the conductive probe arms to be positioned on one surface of the supporting body or, alternatively, in accordance with an alternative embodiment on two opposing surfaces of the supporting body or even on non-opposing surfaces of the supporting body e.g. on neighbouring surfaces of a cubic supporting body.

The first multitude of conductive probe arms on one surface of the multi-point probe according to the first aspect of the present invention consists of a multiple of 2, ranging from at least 2 conductive probe arms to 64 conductive probe arms, having four conductive probe arms positioned on one surface as the presently preferred embodiment. Application of a test signal to the surface of the test sample between the two peripherally positioned conductive probe arms provides a resultant test signal between the two inner conductive probe arms, including information of the electric properties of the test sample.

The first multitude of conductive probe arms of the multi-point probe according to the first aspect of the present invention have a rectangular cross section, with the dimensions defined as: width being parallel to the plane of the surface of the supporting body of the multi-point probe, depth being perpendicular to the plane of the surface of the supporting body of the multi-point probe and, length being the length of the conductive probe arms extending freely from the supporting body of the multi-point probe. The dimension ratios of the first multitude of conductive probe arms comprises ratios such as: length to width within the range 500:1 to 5:1, including ratios 50:1 and 10:1, having the ratio of 10:1 as the presently preferred embodiment, width to depth ratio within the range of 20:1 to 2:1, having the ratio of 10:1 as the presently preferred embodiment. The length of the first multitude of probe arms is in the range of $20\mu m$ to 2mm, having a length of $200\mu m$ as the presently preferred embodiment. The separation of distal end-points of the conductive probe arms ranges from $1\mu m$ to 1 mm, having $20\mu m$, $40\mu m$ and $60\mu m$ as the presently preferred embodiments. However, as previously described the dimensions of the multi-point probe according to the first aspect of the present invention varies as a function of the current state of the art in production technology and are therefore not a limitation to the present invention.

The distal ends of the first multitude of conductive probe arms comprise a variety of optional shapes in continuation of the end of the length opposing the supporting body of the multi-point probe according to the first aspect of the present invention.

The continuation of the length of the freely extending conductive probe arms include shapes as pointed distal end-points, tapered distal end-points or enlarged circular, elliptic or orthogonal squared distal ends or combinations thereof. The elaboration of the distal end-points of the first multitude of the conductive probe arms allows for optimisation of measurements of electric properties of the test sample, that being resistive, capacitive or inductive electric properties of the test sample at frequencies ranging from DC to RF including frequencies in the LF range and the HF range.

The material of the supporting body of the multi-point probe according to the first aspect of the present invention comprises ceramic materials or semi-conducting materials such as Ge, Si or combinations thereof. Use of the semi-conducting materials Ge, Si or combinations thereof allows for the micro-fabrication technology in the manufacturing process of the multi-point probe, hence benefiting from the advantages of the micro-fabrication technology.

The conductive layer on the top surface of the first multitude of conductive probe arms and the conductive layer of the second multitude of conductive electrodes on the multi-point probe according to the first aspect of the present invention is made by conducting materials such as Au, Ag, Pt, Ni, Ta, Ti, Cr, Cu, Os, W, Mo, Ir, Pd, Cd, Re, conductive diamond, metal silicides or any combinations thereof.

Numerous other objects, advantages and features which will be evident from the below detailed description of a presently preferred embodiment of the present invention, are obtained, according to a particular aspect of the present invention, by a multi-point probe for testing electric properties on a specific location of a test sample and further comprising:

(e) a third multitude of conductive tip elements extending from said distal end of said first multitude of conductive probe arms; and
(f) said conductive tip elements originating from a process of metallization of electron beam depositions on said first multitude of conductive probe arms at said distal ends thereof.

This particular aspect of the presently preferred embodiment of the present invention may provide an extremely small separation of conductive tip elements and therefor may provide a measuring tool for a wide variety of possible test samples having extremely small dimensions.

The third multitude of conductive tip elements may comprise a primary section and a secondary section, the conductive tip elements are connected to the conductive probe arms through respective primary sections thereof and the secondary sections defining free contacting ends. This may provide several optional configurations and designs of the multi-point probe.

The multi-point probe according to the particular aspect of the present invention defines a first axial direction for each of the primary sections, the first axial direction constituting an increase of the total distance between the supporting body and the free contacting ends. The axial direction of the primary section constitutes a decrease of separation between the free contacting ends of the third multitude of conductive tip elements or constitutes a decrease of separation between free contacting ends of the third multitude of conductive tip elements being adjacent Furthermore a second axial direction is defined for each of the secondary sections, the second axial direction constituting an increase of the total distance between the supporting body and the free contacting ends. The second axial direction of the secondary section constitutes a decrease of separation between the free contacting ends of the third multitude of conductive tip elements. The secondary axial direction of the secondary section constitutes a decrease of separation between the free contacting ends of the third multitude of conductive tip elements being adjacent.

Additionally, the first axial direction of the primary sections extends in a direction parallel to the plane defined by the first surface of the supporting body or in a direction converging towards the plane defined by the second surface of the supporting body. Likewise the second axial direction of the secondary sections extend in a direction parallel to the plane defined by the first surface of the supporting body or in a direction converging towards the plane defined by the second surface of the supporting body. These design configurations provide a wide scope of possibilities for testing a wide variety of test samples.

The third multitude of conductive tip elements may be equal to the first multitude of conductive probe arms, less than the first multitude of conductive probe arms, or greater than the first multitude of conductive probe arms, the preferable application having third multitude of conductive tip elements being dividable with 2.

The third multitude of conductive tip elements have a separation of the free contacting ends of the conductive tip elements in the range of 1 nm - 100 nm, preferable application having the separations of 2 nm, 5 nm, 10 nm, 20 nm, 50 nm, 100 nm.

The dimension of the conductive tip elements define an overall length as distance between the distal ends of conductive probe arms and the free contacting ends of the conductive tip elements, the overall length is in the range of 100 nm to 100 $\mu$m, the preferable appli-

cation having the overall length in the ranges 500 nm to 50 $\mu$m and 1 $\mu$m to 10 $\mu$m, and define a diameter, the diameter being in the range of 10 nm to 1 $\mu$m, preferable application having the overall length in the ranges 50 nm to 500 nm.

The material utilised in producing the third multitude of conductive tip elements may mainly consist of carbon and further consist of a concentration of contaminants.

The third multitude of conductive tip elements may originate from a process of tilted electron beam deposition, a process of perpendicular electron beam deposition, or a process of a combination of tilted electron beam deposition and perpendicular electron beam deposition. The metallization of the third multitude of conductive tip elements may originate from a process of in-situ metallic deposition or a process of ex-situ metallic deposition.

The object of the present invention Is to realize the known principle of motion in a much simpler way mechanically. Specifically, In the present invention the frictional forces are caused by intrinsic elastic forces in the moving part and the substrate. To achieve this the moving part and the substrate are machined with very high precision in diameters and surface roughness.

The advantages of the present invention over previous implementations of the known principle of motions are many:

> 1. The frictional forces between the moving part and the support are independent of outer forces and thus also of the orientation relative to the surroundings.
> 2. The invention has complete cylindrical symmetric thereby making it very insensitive to temperature variations.
> 3. The forces supporting the moving part in the invention are evenly distributed on the outer surface thereby giving a large support area which give an unparalleled mechanical stability.
> 4. The invention includes a minimum of moving parts.
> 5. The distributed area of friction between the moving part and the support constitutes a hydrodynamical seal, making the invention applicable in micro-pipette and micro-valve systems.

A second object of the invention is to provide a means for positioning a specific point in space with very high precision. For example, a microscopic probe could be attached to this point.

A third object of the invention is to provide new method of actuating the motion of the moving part using only harmonic signals. This method is easy to control electrically and extends the lifetime of the actuator.

A fourth object of the invention is to provide a micro-pipette apparatus which can control extremely small volumes of gas or liquid.

A fifth object of the invention is to provide a micro-valve apparatus which can control flow of gas or liquid to extreme precision.

In order to attain the foregoing objects, the present invention provides one or two inertial members fixed to the distal end of one or two electro-mechanical mechanical actuators, the actuators fixed to a movable member which is movably supported by a surrounding substrate in such a way that distributed intrinsic frictional forces exist between the movable member and the substrate. The distributed intrinsic frictional coupling between the moving member and the substrate provides a hydrodynamic seal. By applying electrical fields on the electro-mechanical actuators, the moving member is moved relative to the support.

> (i) means for receiving and supporting said test sample;
> (ii) electric properties testing means including electric generator means for generating a test signal and electric measuring means for detecting a measuring signal;
> (iii) A multi-point probe, comprising:
>
> > (a) a supporting body;
> > (b) a first multitude of conductive probe arms positioned in co-planar relationship with surface of said supporting body, and freely extending from said supporting body, giving individually flexible motion of said first multitude of conductive probe arms; and
> > (c) said conducting probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
> > (d) said multi-point probe communicating with said electric properties testing means; and
>
> (iv) nano-driving means for reciprocating said multi-point probe relative said test sample so as to cause said conductive probe arms to be contacted with said specific location of said test sample for performing said testing of electric properties thereof.

**Brief description of the drawings**

Additional objects and features of the present invention will be more readily apparent from the following detailed description and appended claims with taken in conjunction with the drawing, in which:

> Figure 1, provides an overall illustration of the conventional four-point probe measurement technique on a test sample;
>
> Figure 2, shows a detailed illustration of the measurement technique depicted in figure 1;

Figure 3, depicts the substrate after patterning a deposited support layer;

Figure 4, illustrates the formation of the cantilevers by removal of part of the substrate;

Figure 5, depicts the etching of the substrate to undercut the pattern in the support layer,

Figure 6, depicts the deposition of an electrically conducting layer;

Figure 7, depicts a set-up for measuring a test sample using a multi-point probe made in accordance with the present invention;

Figure 8, illustrates a set-up having a multi-point probe made in accordance with the present invention mounted on an optical microscope;

Figure 9, pictures a detachable multi-point probe in a semi-conducting wafer;

Figure 10, shows a principal diagram of the circuit used for performing measurements, comprising an electrometer and a current source;

Figure 11, shows an electron beam deposition. (a), shows a perpendicular electron beam disposition and (b), shows a tilted electron beam deposition either on the substrate or as continuation on top of an previously produced tip;

Figure 12, shows metallization of tip. (a), shows in-situ metallization of tip applying conducting contaminants and (b), shows ex-situ metallization of tip applying subsequent metallization;

Figure 13, shows probe geometry having tips extending from probe arms;

Figure 14, shows general tip configurations. (a), shows 2-tip, (b), shows 4-tip having non-uniform tip spacing, (c), shows 4-tip, (d)-(f), shows (a)-(c) having secondary tips;

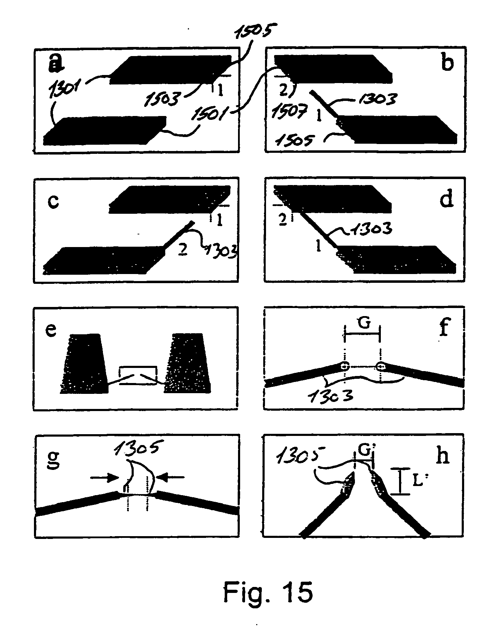

Figure 15, shows tip fabrication of probe. (a), shows initial view. A tip is grown on probe arm 1. (b), shows the sample rotated/tilted hereby obtaining a mirrored view. A tip is grown on probe arm 2 on the pointing line of tip 1. (c)-(d), shows the result of repeating the procedure until the gap G is slightly larger than the intended gap G'. (e), shows the sample rotated to obtain a frontal view, however additionally tilted to obtain the chosen angle $\alpha$' of the secondary tips. (f)-(g), shows the secondary tips grown on both tip ends. (h), shows the intended gap G' and the lengths tuned by repeating steps (f)-(g);

Figure 16, shows scanning electron microscope pictures of the fabrication sequence (identical to figure 15). (a)-(c), shows initial growth of tip 1 and 2. (d)-(f), shows second iteration. (g)-(I), shows third iteration resulting in gap G' of 300 nm. (j), shows initial growth of secondary tips. (k), shows the secondary tips after narrowing in the gap and fine tuning the lengths to within 10 nm. (I) Overview picture of finished probes;

Figure 17 illustrates the conventional apparatus for effecting fine movement;

Figure 18(a)-(c) are views of embodiments of the nano-positioning apparatus according to the present invention;

Figure 19(a)-(b) are views of a micro-pipette apparatus according to the present invention;

Figure 20(a)-(b) are views of a micro-valve apparatus according to the present invention;

Figure 21(a)-(c) are views of embodiments of the positioning apparatus according to the present invention;

Figure 22(a)-(c) are curve-forms illustrating the electrical fields to be applied to a single electro-mechanical actuator on the moving member of the present invention for effecting movement of said member;

Figure 23(a)-(b) are curve-forms illustrating the electrical fields to be applied to two electro-mechanical actuators fixed at opposing sides of the moving member of the present invention for effecting movement of said member;

Figure 24 is a view schematically showing a micro-pipette apparatus according to the present invention;

Figure 25 is a view schematically showing a micro-valve apparatus according to the present invention;

Figure 26(a)-(b) are views schematically showing embodiments of a nano-positioning apparatus according to the present invention.

## Detailed description of the preferred embodiments.

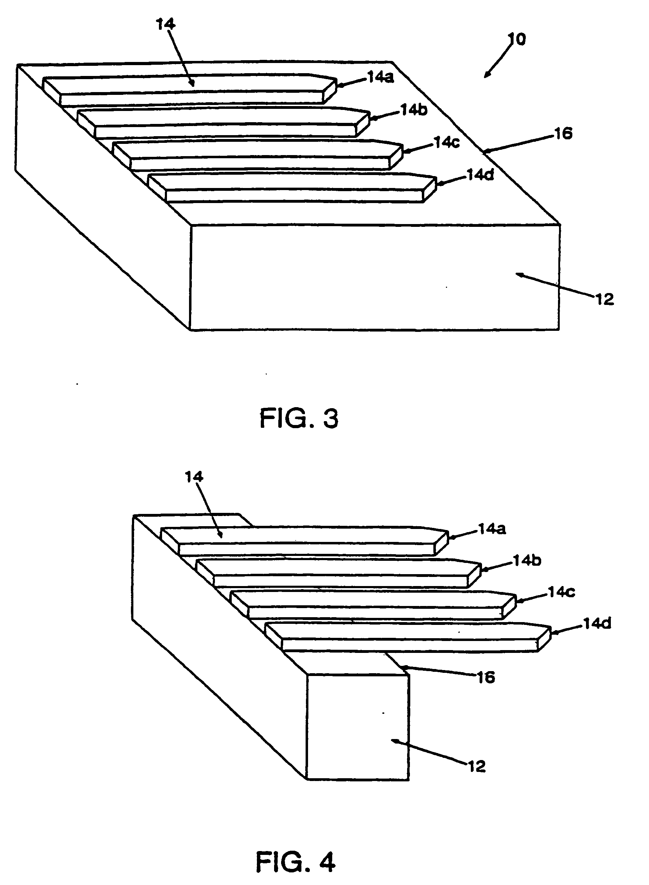

A preferred embodiment is directed toward making a multi-point probe and is described with respect to figures 3-6.

Figure 3 shows a wafer **10,** for example a section of a semiconductor wafer, in intermediate state of fabrication. It shows a surface **16** of a substrate **12** covered by a support layer **14,** being electrically isolating, such as silicon oxide. The deposition of the support layer **14** can be accomplished by any technique known in the art, such as chemical vapour deposition (CVD), plasma enhanced CVD (PECVD), electron cyclotron resonance (ECR) or sputtering. As shown in figure 3, the support layer **14** is patterned and etched to form beams with tapered end-points **14a-d.** The beams are not limited to any particular form or symmetry; they can be of any geometry with suitable end-points.

The pattern is formed by forming a photoresist pattern (not shown in figure 3) which defines the four beams on the top surface of the support layer **14.** The photoresist pattern is formed by conventional photolithographic photoresist formation, exposure, development and removal techniques. The support layer is then etched using any technique known in the art, such as dry etching or wet etching, until the unmasked parts of the support layer **14** are removed from the top surface of the substrate.

In an alternative embodiment of the present invention the four beams or part of them can be defined using high-resolution lithographic methods such as electron-beam lithography, atomic force microscopy (AFM) lithography or laser lithography.

Once the support layer has been patterned, the substrate is partially removed to release the patterned support layer, forming four cantilevers with sharpened end-points **14a-d,** as illustrated in figure 4.

In the preferred embodiment, the substrate is removed by depositing a protective layer (not shown in figure 4) of silicon nitride on top and bottom surface of the substrate **12.** Next, a photoresist pattern is formed on the bottom surface of the substrate by conventional photolithographic photoresist formation, exposure, development and removal techniques. The nitride layer is then removed in the unmasked areas on the bottom surface of the substrate using Reactive Ion Etch (RIE) in a plasma containing $SF_6$ and $O_2$ or similar reagents, and the substrate is etched using an etching chemistry comprising potassium hydroxide (KOH) or a similar chemistry until the freely extending probe arms are exposed. Then the protecting layer of nitride is removed from the top surface of the substrate using RIE, or using wet etching with a chemistry comprising phosphoric acid ($H_3PO_4$) or a similar chemistry.

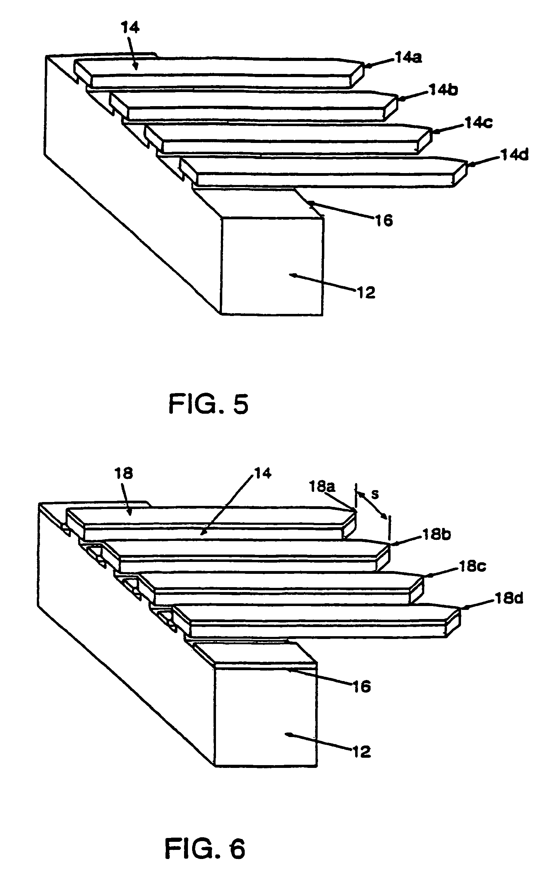

Figure 5, illustrates the etching of the substrate **12** to undercut the support layer **14.** In the preferred embodiment, this etching step is performed with a dry etching method, such as an isotropic RIE etch.

The final stage of fabrication is shown in figure 6, and involves the deposition of an electrically conducting layer **18** on the top surface of the wafer. The conducting layer is made of conducting materials like Au, Ag, Pt, Ni, Ta, Ti, Cr, Cu, Os, W, Mo, Ir, Pd, Cd, Re, conductive diamond, metal silicides or combinations thereof. Alternatively the conducting layer can be made of a highly doped semiconducting material. The conducting layer can be deposited using electron-beam evaporation, or any other similar technique known in the art. Due to the undercutting of the support layer **14,** the electrically conducting layer will not create conducting paths between the four beams made in the support layer, and thus four isolated electrodes are formed on the top surface of the support beams, and thus points **18a-d** can be connected through the beams to an external positioning and measuring device (not shown in figure 6).

As shown in figure 6 the deposition of the conducting layer creates electrodes on the substrate. In a preferred embodiment these electrodes are used for active guarding of the conductive probe arms to significantly reduce leakage resistance and, consequently, increase the measuring accuracy of the invention.

Referring again to figure 6, in the present invention the minimum probe end-point separation s is approximately 1 $\mu$m. The minimum probe end-point separation is however determined by the current state of the art in micro-fabrication technology and not any limitation of the present invention. Thus, as micro-fabrication technology produces smaller and smaller devices, the minimum probe end-point separation s can also be reduced.

In operation an external positioning device places a multi-point probe made according to the present invention into physical contact with the surface of the test sample. Once electrical contact between the surface of the test sample and all four conductive probe arms has been achieved, a current is applied to two of the conductive probe arms and a corresponding voltage is measured between the two other conductive arms. The method for applying the current and detecting the voltage can be any method known in the art.

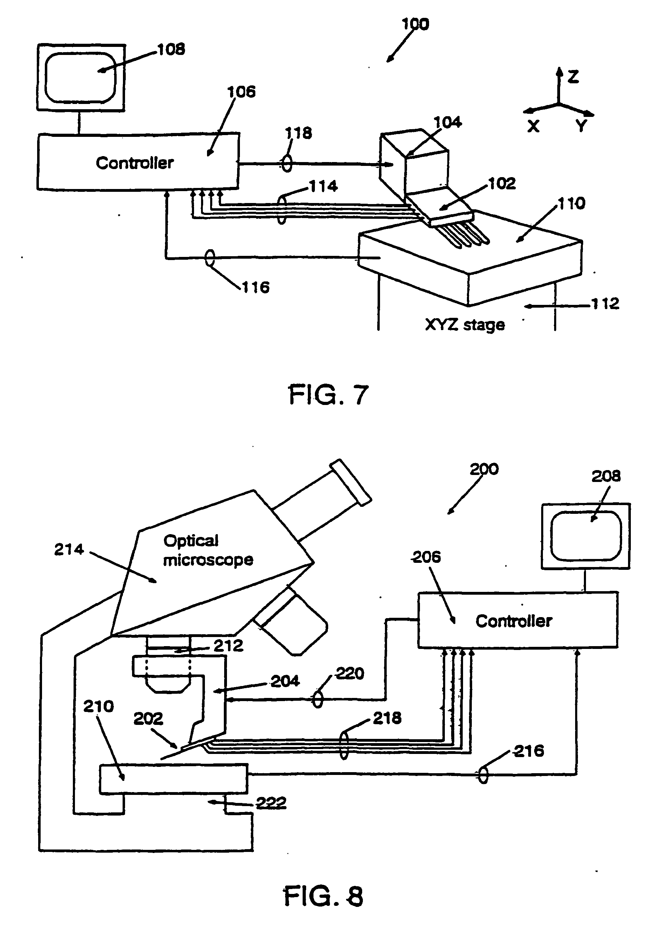

The preferred embodiment of the multi-point testing apparatus of the present invention is shown in figure 7. The figure depicts a multi-point testing apparatus **100,** a test sample **110** is mounted on a stage **112** with an XYZ positioning mechanism. This mechanism can be controlled automatically or manually. A multi-point probe made according to present invention **102** is mounted above the surface of the test sample on a probe holder **104** which can be moved in the Z direction with a resolution of 0.1 $\mu$m or better. Optionally the probe holder **104** can be controlled with similar spatial resolution in the X and Y directions. The set-up **100** is similar to that of an AFM or a Scanning Tunnelling Microscope (STM). Connections **114** from the probe end-points are input to a controller **106,** which can move the multi-point probe with respect to the test sample **110.** Optionally a connection **116** from the test sample **110** can also be input to the controller **106.** The controller **106** can be a computer or a programmed micro-controller. By monitoring the four point resistance using the end-points of the four probe arms or the two point resistances between the end-points of the four probe arms and the test sample **110,** the controller **106** can move the multi-point probe towards the test sample until all end-points of the four probe arms are in physical contact with the test sample. By holding the multi-point probe having the probe arm lengths in an angle relative to the surface of the test sample **110,** smaller than perpendicular and larger than parallel, full individual probe arm flexibility is achieved, providing a safe mode of operation in regards to avoiding destruction of single devices on top surface of test sample. Then a measurement can be made of the test sample resistivity, and the controller **106** analyses the measured data and displays measurement information on display **108.** The controller **106** may retract the multi-point probe, move the test sample **110** in the XY plane and repeat the procedure.

Figure 8 illustrates a similar apparatus **200** where the test sample stage consists of a XY positioned **222** on a standard optical microscope **214.** A multi-point probe made in accordance to the present invention **202** is placed on a probe holder **204,** which is mounted on a microscope objective **212,** allowing the operator to identify features on the test sample surface and perform four point probe measurements at these features. In this manner μm sized test sample features such as single microelectronic devices or polycrystalline grains can be probed in a controlled fashion. Similar to the previously described apparatus **100,** illustrated in figure 7, the four leads 218 from the probe are input to a controller **206** as well as a lead **216** connecting to the test sample; the controller outputs signals **220** controlling the movement of the probe holder, and the controller **206** analyses and presents the measurement data on display **208.**

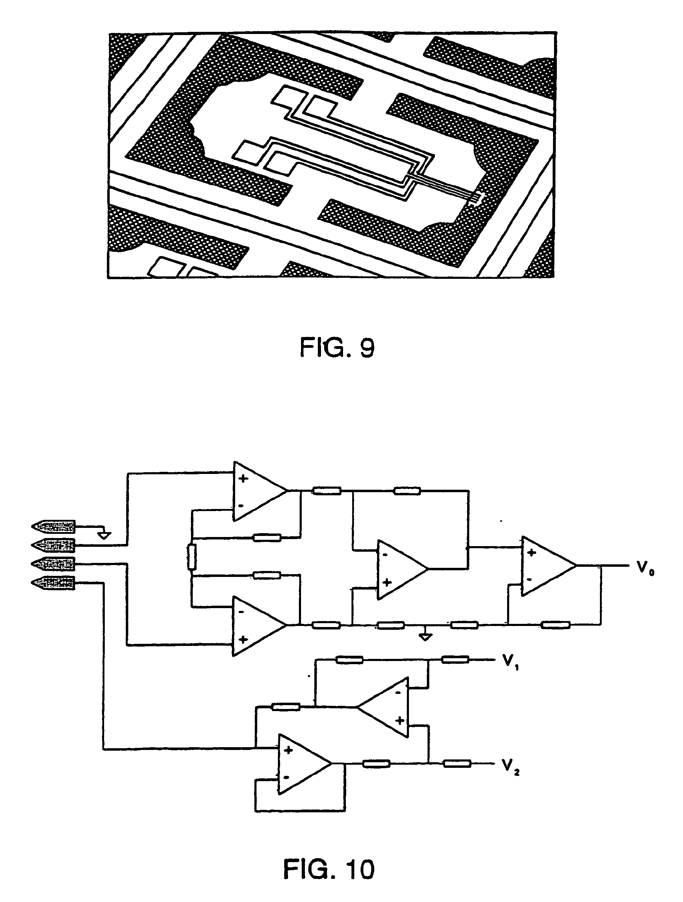

Figure 9, pictures a detachable multi-point probe in a semi-conducting wafer. A wafer can consist of several multi-point probes, which are detachable from the wafer. This production technique provides an extremely repeatable and safe method of fabrication of multi-point probes.

Figure 10, shows a principal diagram of the circuit used for performing measurements, comprising an electrometer and a current source. Applying integrated circuit techniques for the fabrication of multi-point probes enables the possible integration of the electrometer, current source and additional circuit on the wafer.

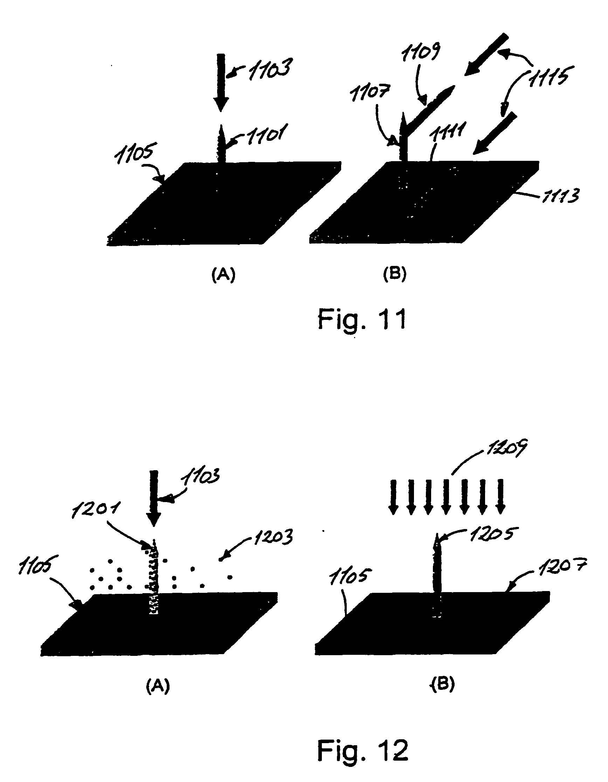

A particular preferred embodiment of the present invention utilises electron beam deposition techniques for growing tips on probe arms. Figure 11 (a), shows such an electron beam deposition grown from a surface **1105** of a probe arm having the electron beam **1103** in a perpendicular relation to the surface thus creating a primary tip **1101** having an axis perpendicular to surface plane. By tilting an electron beam **1115** in relation to a surface **1113** a tilted electron beam deposition grows either on the surface **1113** of substrate as a primary tip **1111** or as a secondary tip **1109** in continuation on top of a previously produced tip **1107** perpendicular to the surface **1113.**

The electric properties of the tips may be modified by applying contaminants **1203** to a tip **1201** utilising an injection of metallo-organic compound at low partial pressure, hereby obtaining tips with resistances as low as 900 Ω (in-situ metallization). The electric properties of the tips may also be modified by applying a metallic cloud or evaporation **1209** creating metallic layers **1205,1207** on the tip **1201** and on the surface **1105** subsequent to finalising the tip growth (ex-situ metallization). By applying subsequent evaporations **1209** using two or more application angles a good metallic coverage of the tip **1101** and the surface **1105** are achieved, thus providing useful tips **1101.** Figure 12, shows both methods for metallization of tips.

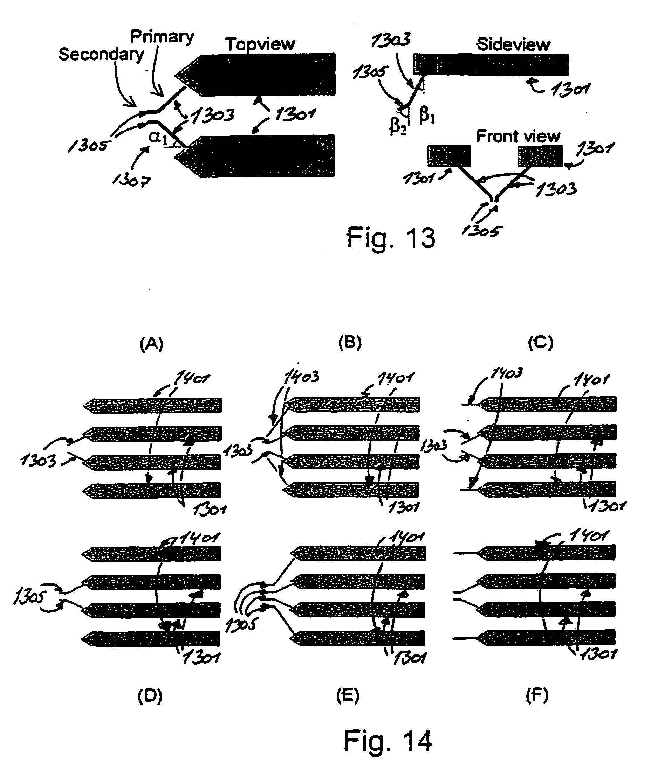

The geometry of a probe is shown in Figure 13 in top view, side view and front view. The probe is shown having to probe arms **1301** on to which primary tips **1303** have been grown by utilising electron beam deposition. The primary tips **1303** create an angle **1307** (α1) between direction of axial length of the probe arm **1301** and direction of axial length of primary tips **1303.** Secondary tips **1305** extend from the primary tips **1303** on the probe arms **1301.** The primary tips **1303** furthermore have an inclination **1309** (β1) and the secondary tip **1305** and additional inclination **1311** (β2) in relation to the direction of the axial length of the probe arm **1301.**

Several tip configurations are shown in figure 14. Figure 14 (a) shows four parallel probe arms, two outer probe arms **1401** and the two inner probe arms **1301** having two primary tips **1303** positioned on the two inner probe arms **1301.** The two primary tips **1303** create an angle in relation to axial direction of the inner probe arms **1301** such that the primary tips **1303** point a common orientation. Figure 14(b) shows the four parallel probe arms **1301,1401** having four primary tips **1303,1403** positioned so that the end point have equal tip separations. Figure 14(c) shows the four probe arms **1301,1401** each having primary tips **1303,1403** extending from distal end. The two inner probe arms **1301** having the primary tips **1303** pointing toward a common orientation and the two outer probe arms **1401** pointing toward in axial direction of the outer probe arms **1401.** Figures 14(d) to (f) show secondary tips **1305,1405** added to the primary tips **1303,1403.**

The fabrication scheme for producing primary and secondary tips applying electron beam deposition is shown in figure 15. Figure 15(a) shows the two probe arms **1301** having distal ends defined as **1501** and **1505.** The electron beam is aimed at a corner **1503** of the surface of the distal end **1505,** hereby producing the primary tip **1303.** As shown in figure 15(b) the electron beam is subsequently aimed at a corner **1507** of the surface of the distal end **1501,** hereby producing the second primary tip **1301.** This procedure is repeated until the separation between the two primary tips **1301** is slightly larger than the intended gap G' between the primary tips **1301.** The primary tips **1303** create an angle in relation to axial direction of probe arms **1301** and an angle in relation to the surfaces of the distal ends **1501,1505** such that the primary tips **1303** point away from the supporting body of the multi-point probe. The secondary tips **1305** furthermore create an angle in relation to axial direction of the primary tips **1303.** In order to achieve this secondary angling of the secondary tips **1305** in relation to the primary tips **1301** the multi-point probe is rotated as shown in figure 15(e).

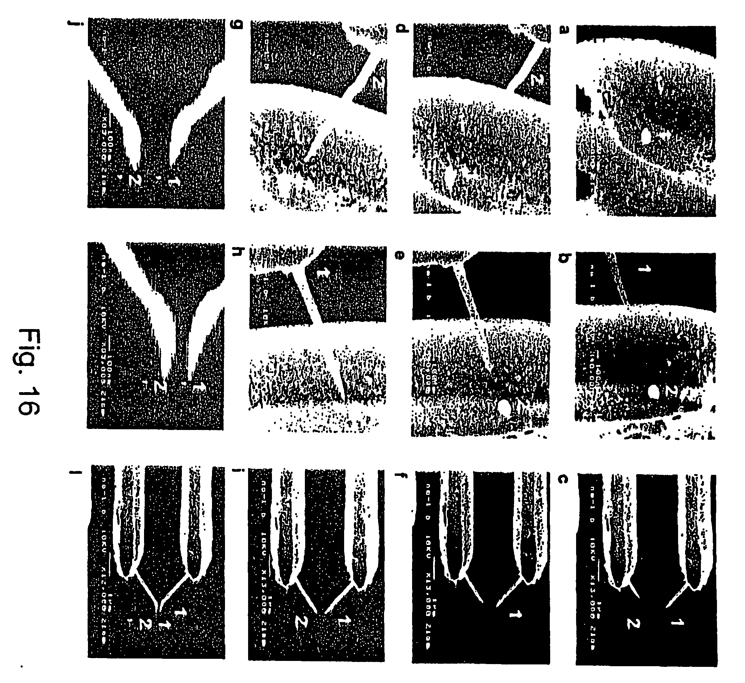

Figure 16, shows electron microscope pictures of the fabrication scheme presented above and in figure 15.

As shown in figure 18a, a preferred embodiment of the cylindrical nano-drive includes a cylindrical movable member **1803** movably supported in a surrounding substrate **1801.** An electro-mechanical actuator **1805** is fixed on the movable member, and an inertial member **1807** is fixed in the distal end of said actuator. A distributed intrinsic frictional force exists between the movable member and the support. This frictional force originates from the internal elastic forces of the movable member and the support, and appears because of a high-precision machining of the movable member and the support. In a preferred embodiment, the support and the movable member is machined to fit within a tolerance of the diameter of less than one micrometer. This fit can be performed using milling, drilling, etching, honing, polishing, lapping, or any other known technique for machining of materials. In a preferred embodiment the movable member and the support consists of chemically inert, hard materials such as semiconductor carbides or nitrides. The electro-mechanical actuator has at least two electrodes to allow it to be moved in a direction parallel with the travel of the movable member. In a preferred embodiment the electro-mechanical actuator is a piezoelectric tube with one inner electrode and four outer electrodes, to provide both transverse and longitudinal motion of the actuator and thus of the inertial member.

In a second embodiment, the movable member in the cylindrical nano-drive according to the invention is a hollow tube which is closed in one end, as shown in figure 18b. The electro-mechanical actuator is fixed to the bottom of the tube.

In a third embodiment, the movable member in the cylindrical nano-drive according to the invention is a hollow tube which is closed in one end, and is movably supported on the inside of the tube as shown in figure 18c.

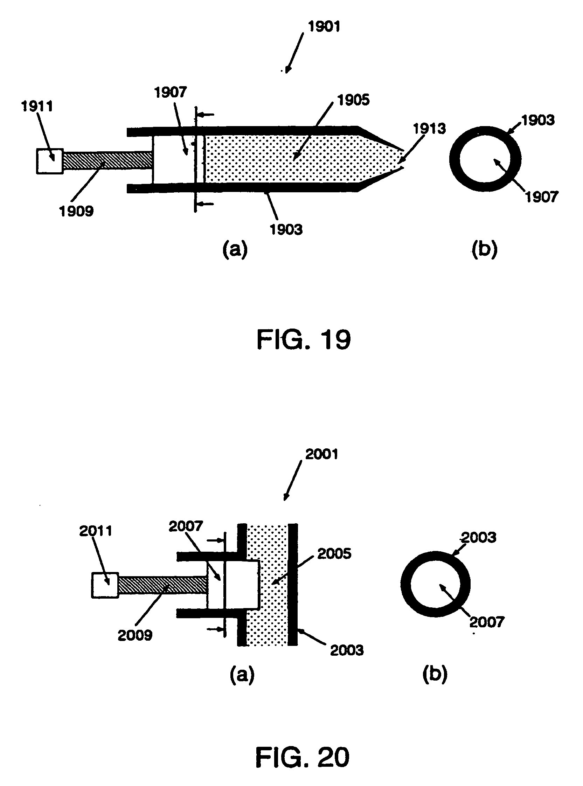

Figure 19a shows an embodiment of a micro-pipette **1901** according to the invention. The micro-pipette consists of a cylindrical nano-drive according to the invention, which has a movable member **1907** movably supported inside a tube **1903,** said tube having an opening **1913** through which very small amounts of liquid or gas can be dispensed or acquired. An electro-mechanical actuator **1909** is fixed to the movable member, and an inertial member **1911** is fixed to the distal end of the actuator. The position of the movable member is controlled by electrical signals applied to the electro-mechanical actuator in such a way that the volume of gas or liquid in the tube is controlled with very high accuracy. Figure 19b shows a sectional view of the micro-pipette.

Figure 20a shows an embodiment of a micro-valve **2001** according to the invention. The micro-valve consists of a cylindrical nano-drive according to the invention, which has a movable member **2007** movably supported inside a tube **2003** which has two openings through which a gas or liquid **2005** is flowing. The movable member can completely or in part block said flow by applying electrical signals to the electro-mechanical actuator **2009** which is fixed to the movable member, and thus the flow can be controlled with a very high degree of accuracy. Figure 20b shows a sectional view of the micro-valve.

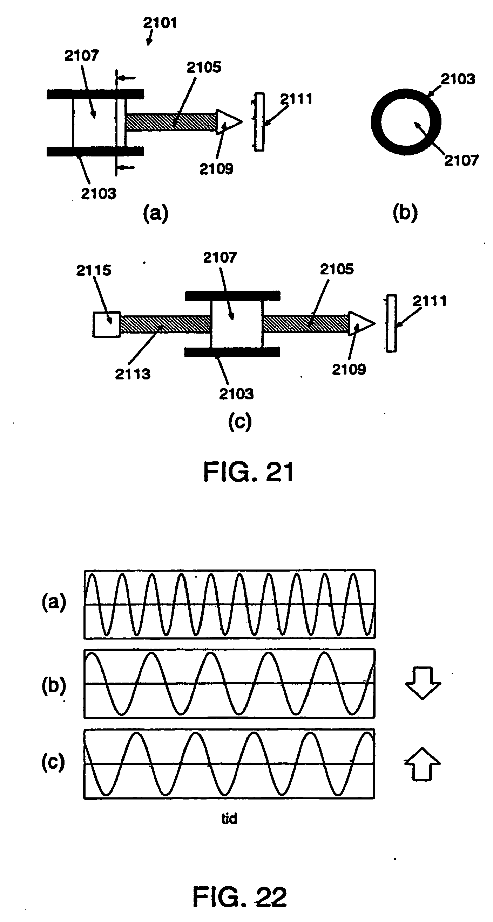

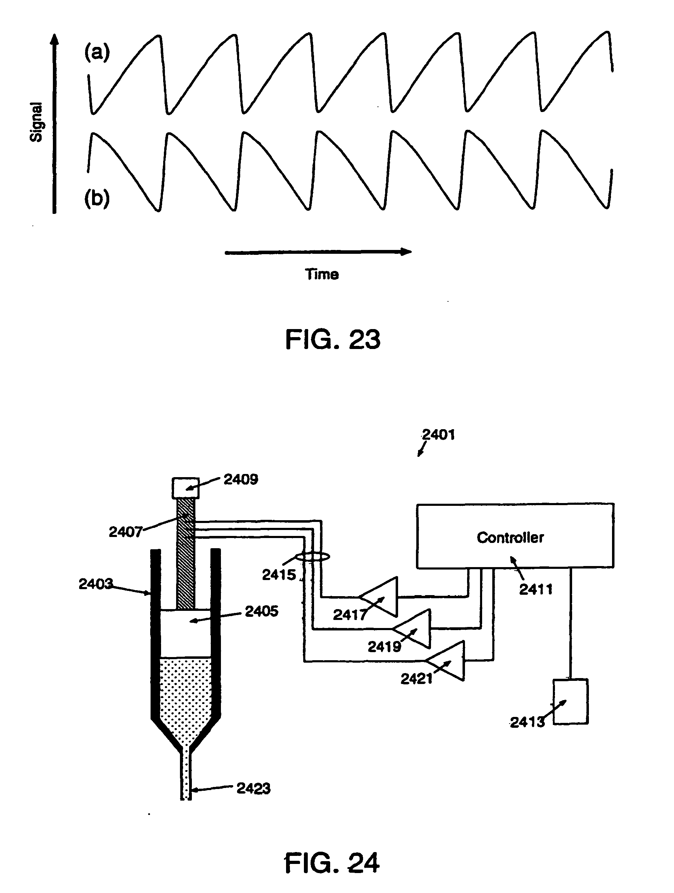

Figure 21a shows an embodiment of a nano-positioner **2101** according to the invention. The nano-positioner consists of a cylindrical nano-drive according to the invention with a movable member movably supported by a tubular substrate **2103**. The position of the substrate can be changed by applying electrical signals to the electro-mechanical actuator **2105.** In the distal end of the actuator is fixed a probe **2109** which is also the inertial member of the cylindrical nano-drive. The probe can be moved in all directions relative to a material **2111** by applying electrical signals to the electro-mechanical actuator. Figure 21b shows a sectional view of the nano-positioner. Figure 21c shows an alternative embodiment of the nano-positioner where the movable member has two actuators fixed at opposing sides. The additional actuator **2107** has an inertial member **2113** fixed at the distal end. The actuator **2113** can be controlled independent of the actuator **2105** which allows the probe to be move continuously over distances of millimeter in the direction of movement of the movable member relative to the material. The electrical fields necessary to achieve this are shown schematically in figures 23a-b. A sawtooth-like waveform is applied to one of the actuators, while a similar waveform of opposing sign is applied to the other actuator. By fine-tuning of the amplitude and phase of the two waveforms, a continuous movement of the probe will appear.

Figures 22a-c shows curve-forms for electrical signals to control the movement of the movable member in a cylindrical nano-drive according to the invention in which the actuator can be moved in both transverse and longitudinal directions. The longitudinal movement of the actuator is controlled by a harmonic oscillating signal as shown in figure 22a. When one or both transverse movements are driven by a harmonic oscillating electrical signal with half the frequency of the longitudinal signal, and when all extrema on the transverse signal coincide with either maxima or minima in the longitudinal signal, then the movable member will be displaced either up or down. These curve-forms are shown in figures 22b-c. By changing the amplitude and the frequency of the harmonic signals, the movement of the movable member per period of the harmonic signal can be made arbitrarily small.

Figure 24 shows schematically a complete micro-pipette apparatus **2401** according to the invention. The micro-pipette is constructed as described above with reference to figure 19, with the movable member **2405** movably supported inside a tube **2403** which is tapered into a pipette tip **2423.** On the movable member is fixed an electro-mechanical actuator **2407** which has an inertial member **2409** fixed to the distal end. The electrodes on the electro-mechanical actuator are connected to a control-box **2411** through amplifiers **2417 - 2421** with electrical wires **2415**. The control box can include a computer, a microprocessor or discrete digital or analog components. The control box can be controlled remotely by a computer or with a panel **2413** on which the speed and direction of the movable member can be selected.

In a more advanced embodiment of the micropipette apparatus, the micro-pipette is attached to a manual or motorized stage, in such a way that the micropipette tip can be moved relative to the media in which gas or liquid is to be dispensed or extracted. In the case of an motorized stage, an automatic micro-pipette system is realized, in which the micro-pipette and perform movements synchronized with dispensing or extracting fluid or gas.

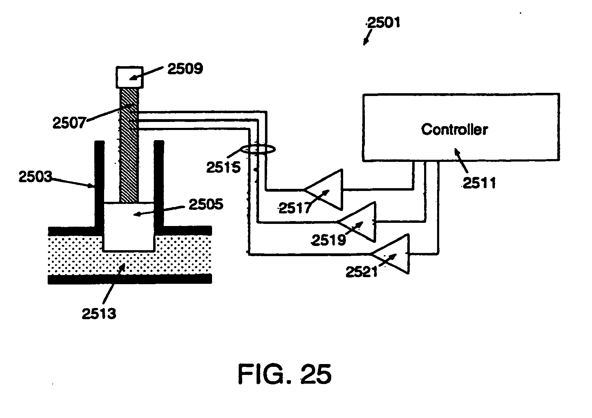

Figure 25 shows schematically a complete micro-valve apparatus **2501** according to the invention. The micro-valve is constructed as described above with reference to figure 20, with a movable member **2505** movably supported inside a tube **2503** in which a transverse flow of gas or liquid **2513** is present. On the movable member is fixed an electro-mechanical actuator **2507** which has an inertial member **2509** fixed to the distal end. The electrodes on the electro-mechanical actuator are connected to a control-box **2511** through amplifiers **2517 - 2521** with electrical wires **2515**. The control box can include a computer, a microprocessor or discrete digital or analog electronic components.

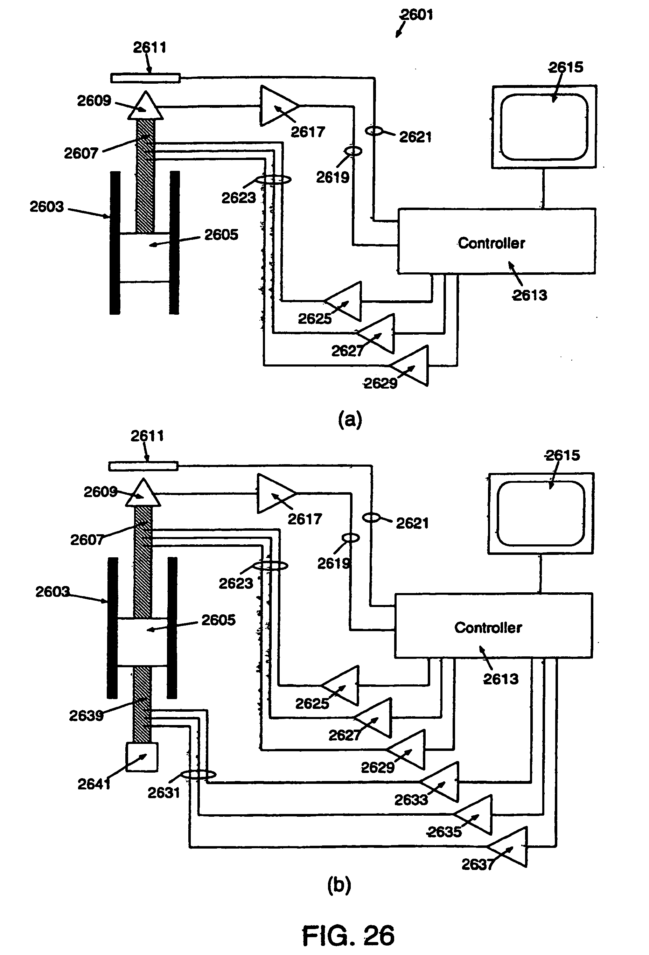

Figure 26a shows schematically a complete nano-positioner apparatus **2601** according to the invention. The nano-positioner apparatus is constructed from an embodiment of the cylindrical nano-drive according to the invention in which the inertial member **2609** comprises a microscopic probe, for example a very sharp electrode. The nano-positioner apparatus can move the probe relative to a sample **2611**. An electrical connection **2619** from the probe can be sent though an amplifier **2617** to a control box **2613**. An electrical connection **2621** can also be made between the sample and the control box. The control box contains a feedback system which uses the electrical signal from the microscopic probe to adjust the position of the microscopic probe relative to the sample. The position of the probe is controlled by at least one electrical connection **2623** between the control box and the electro-mechanical actuator **2607** on the movable member **2605** of the cylindrical nano-drive, which is movably supported in a surrounding substrate **2603**. The electrical signal to the actuator can pass through an amplifier **2625 - 2629**. In a preferred embodiment the actuator comprises a piezoelectric tube with electrodes allowing transversal and longitudinal movement of the microscopic probe with respect to the sample. In this way a scan of the sample material can be obtained as a function of position, and the obtained data can be presented on a display **2615** connected to the control box.

Figure 26b shows an alternative embodiment of the nano-positioner apparatus, further comprising a second electro-mechanical actuator **730** fixed to the movable member of the cylindrical nano-drive according to the invention. A inertial member **732** is fixed to the distal end of the electro-mechanical actuator. There is at least one electrical connection **2631** between the second electro-mechanical actuator and the control box. The electrical signal can pass though an amplifier **2633 - 2637**.

**Example showing the usage of the multi-point probe.**

The probe chips (illustrated in figure 9) are broken out of the wafers and are mounted on ceramic dies (5mm x 10mm) with four big thick-film electrode pads, using epoxy. The conductive probe arms on the silicon chips are connected to the pads on the ceramic dies by bonding $25\mu m$ thick gold wires between them, using a Kulicke-Soffa wedge-bonding machine.

The ceramic chips are fixed mechanically and contacted electrically on an aluminium mount, which is machined to fit around a microscope objective on a Karl-Suss probe station. The mount allows the conductive probe arms of the multi-point probe to be in focus in the middle of the field of view of the microscope. The test sample can then be moved into focus using the normal vertical stage of the microscope. When the test sample is in focus the multi-point probe will contact the test sample and a measurement can be performed. This set-up is similar to the general illustration in figure 8.

Electronics consisting of an electrometer and a current source is built into the aluminium mount to minimise the distance between the probe and the electronics. This keeps the noise in the measurements at a minimum. The principal diagram of the circuit is shown in figure 10. The two inner conductive probe arms of the multi-point probe are connected to an electrometer (an instrumentation amplifier) with an input impedance of more than $10G\Omega$ and an amplification factor of 5000. The peripheral two conductive probe arms of the probe are connected to the current source (a differential voltage to current converter) which delivers an adjustable output in the range of 10nA to $1\mu A$. The current output is proportional to the voltage difference V1-V2. These voltages are generated externally by a computer equipped with a digital to analogue converter. The same computer detects the output voltage Vo of the electrometer through an attached analogue to digital converter. Batteries power the circuit in order to make it float with respect to ground.

A measurement is performed by sampling the voltage of the electrometer for both polarities of the current, taking the average of the two values. This averaging procedure is useful for eliminating thermal drift in the electronics.

**Claims**

1.  A multi-point testing apparatus (100) for testing electric properties on a specific location of a test sample (110), comprising:

    means (104) for receiving and supporting said test sample;
    electric properties testing means (106) including electric generator means for generating a test signal and electric measuring means for detecting a measuring signal;
    a multi-point probe (102), comprising:

    a supporting body (12) originating from a wafer body;
    a first multitude of conductive probe arms (14a, 18a; 14b, 18b; 14c, 18c; 14d, 18d) positioned in co-planar relationship with a surface (16) of said supporting body, and freely extending from said supporting body (12), giving individually flexible motion of said first multitude of conductive probe arms (14a, 18a; 14b, 18b; 14c, 18c; 14d, 18d); and
    said conducting probe arms (14a, 18a; 14b, 18b; 14c, 18c; 14d, 18d) originating from a process of producing said multi-point probe (102) including producing said conductive probe arms (14a, 18a; 14b, 18b; 14c, 18c; 14d, 18d) on said wafer body in facial contact with said wafer body and removal of a part of said wafer body providing said supporting body and providing said conductive probe arms (14a, 18a; 14b, 18b; 14c, 18c; 14d, 18d) freely extending from said supporting body (12);
    said multi-point probe (102) communicating (114) with said electric properties testing means (106); and
    nano driving means (1701, 1703, 1705, 1707) configured for reciprocating said multi-point probe (102) relative said test sample (110) so as to cause said conductive probe arms (14a, 18a; 14b, 18b; 14c, 18c; 14d, 18d) to be contacted with said specific location of said test sample (110) for performing said testing of electric properties thereof.

2.  The multi-point testing apparatus (100) according to claim 1, wherein said electric properties testing means (106) further comprising means for electric properties probing of said test sample (110).

3.  The multi-point testing apparatus (100) according to claims 1 and 2, wherein said nano driving means (1701, 1703, 1705, 1707) further comprises holding means for said multi-point probe (102).

4.  The multi-point testing apparatus (100) according to claim 3, further comprising means for positioning said holding means across said test sample (110) and recording of a location of said holding means relative to said test sample (110).

5.  The multi-point testing apparatus (100) according to claim 4, wherein said means for positioning comprising manoeuvrability in all spatial directions, being directions co-planar to said test sample (110) and directions perpendicular to said test sample (110).

6.  The multi-point testing apparatus (100) according to claims 4 to 5, wherein said means for positioning further comprising means for angular movement of said holding means, such as to provide angular positions for said means for said multi-point probe (102).

7.  The multi-point testing apparatus (100) according to claims 4 to 6, wherein said means for positioning further comprising means for angular movement of said holding means along an axis parallel to surface of said test sample (110), such as to provide angular positions for said means for said multi-point probe (102).

8.  The multi-point testing apparatus (100) according to claims 4 to 7, wherein said means for positioning further comprising means for angular movement of said holding means along an axis perpendicular to surface of said test sample (110), such as to provide angular positions for said means for said multi-point probe (102).

9.  The multi-point testing apparatus (100) according to claims 4 to 8, wherein said means for positioning further comprising means for sensing contact between said test sample (110) and said multi-point probe.

10. The multi-point testing apparatus (100) according to claim 1 to 9, wherein said nano-driving means having a resolution in the range of 1nm to 0.1 $\mu$m in all spatial directions.

11. A method of testing electric properties on a specific location of a test sample (110), comprising:

    a) providing:

    (i) a multi-point testing apparatus (100), having:

    means (104) for receiving and supporting said test sample; and
    electric properties testing means (106) including electric generator means for generating a test signal and electric measuring means for detecting a measuring signal;

and
(ii) a multi-point probe (102), comprising:

a supporting body (12) originating from a wafer body; and
a first multitude of conductive probe arms (14a, 18a; 14b, 18b; 14c, 18c; 14d, 18d) positioned in co-planar relationship with a surface (16) of said supporting body, and freely extending from said supporting body (12), giving individually flexible motion of said first multitude of conductive probe arms (14a, 18a; 14b, 18b; 14c, 18c; 14d, 18d); and said conducting probe arms (14a, 18a; 14b, 18b; 14c, 18c; 14d, 18d) originating from a process of producing said multi-point probe (102) including producing said conductive probe arms (14a, 18a; 14b, 18b; 14c, 18c; 14d, 18d) on said wafer body in facial contact with said wafer body and removal of a part of said wafer body providing said supporting body and providing said conductive probe arms (14a, 18a; 14b, 18b; 14c, 18c; 14d, 18d) freely extending from said supporting body (12);

b) communicating (114) said multi-point probe (102) with said electric properties testing means (106); and
c) reciprocating said multi-point probe (102) relative said test sample (110) by means of nano driving means (1701, 1703, 1705, 1707) so as to cause said conductive probe arms (14a, 18a; 14b, 18b; 14c, 18c; 14d, 18d) to be contacted with said specific location of said test sample (110) for performing said testing of electric properties thereof.

12. The method according to claim 11, reciprocating said multi-point probe (102) relative to said test sample (110) having a resolution in the range of 1nm to 0.1 μm in all spatial directions.


**Patentansprüche**

1. Mehrpunktprüfvorrichtung (100) zum Prüfen von elektrischen Eigenschaften auf einer bestimmten Stelle eines Prüfstücks (110), umfassend:

Mittel (104) zum Aufnehmen und Tragen des Prüfstücks;

Prüfmittel für elektrische Eigenschaften (106) umfassend Stromerzeugermittel zum Erzeugen eines Prüfsignals und elektrische Messmittel zum Erfassen eines Messsignals;
eine Mehrpunktsonde (102), umfassend:

einen Trägerkörper (12), der von einem Halbleiterscheibenkörper herrührt;
eine erste Vielzahl von leitenden Sondenarmen (14a, 18a; 14b, 18b; 14c, 18c; 14d, 18d), die in einer koplanaren Beziehung zu einer Oberfläche (16) des Trägerkörpers positioniert sind und sich vom Trägerkörper (12) frei erstrecken, wodurch der ersten Vielzahl von leitenden Sondenarmen eine individuell flexible Bewegung verliehen wird (14a, 18a; 14b, 18b; 14c, 18c; 14d, 18d); und
wobei die leitenden Sondenarmen (14a, 18a; 14b, 18b; 14c, 18c; 14d, 18d) von einem Prozess zur Herstellung der Mehrpunktsonde (102) herrühren, der ein Erzeugen der leitenden Sondenarmen (14a, 18a; 14b, 18b; 14c, 18c; 14d, 18d) auf dem Halbleiterscheibenkörper in Gesichtskontakt mit dem Halbleiterscheibenkörper und Entfernen eines Teils des Halbleiterscheibenkörpers umfasst, um den Trägerkörper bereitzustellen und die leitenden Sondenarmen bereitzustellen (14a, 18a; 14b, 18b; 14c, 18c; 14d, 18d), die sich vom Trägerkörper (12) frei erstrecken;
wobei die Mehrpunktsonde (102) mit den Prüfmitteln für elektrische Eigenschaften (106) in Verbindung steht (114); und
Nanoantriebsmittel (1701, 1703, 1705, 1707) konfiguriert für Hin- und Herbewegen der Mehrpunktsonde (102) in Bezug auf das Prüfstück (110), um zu bewirken, dass die leitenden Sondenarmen (14a, 18a; 14b, 18b; 14c, 18c; 14d, 18d) mit der bestimmten Stelle des Prüfstücks (110) in Kontakt kommen, um die Prüfung von elektrischen Eigenschaften davon durchzuführen.

2. Mehrpunktprüfvorrichtung (100) nach Anspruch 1, wobei das Prüfmittel für elektrische Eigenschaften (106) ferner Mittel zum Sondieren von elektrischen Eigenschaften des Prüfstücks (110) umfasst.

3. Mehrpunktprüfvorrichtung (100) nach Anspruch 1 und 2, wobei das Nanoantriebsmittel (1701, 1703, 1705, 1707) ferner Haltemittel für die Mehrpunktsonde (102) umfasst.

4. Mehrpunktprüfvorrichtung (100) nach Anspruch 3, ferner umfassend Mittel zum Positionieren der Haltemittel über dem Prüfstück (110) und Aufzeichnen einer Stelle des Haltemittels in Bezug auf das Prüfstück (110).

**5.** Mehrpunktprüfvorrichtung (100) nach Anspruch 4, wobei das Mittel zum Positionieren eine Manövrierbarkeit in allen räumlichen Richtungen umfasst, und Richtungen koplanar zum Prüfstück (110) und Richtungen senkrecht zum Prüfstück (110) sind.

**6.** Mehrpunktprüfvorrichtung (100) nach Anspruch 4 bis 5, wobei das Mittel zum Positionieren ferner Mittel für eine Winkelbewegung der Haltemittel umfasst, um Winkelpositionen für die Mittel für die Mehrpunktsonde (102) bereitzustellen.

**7.** Mehrpunktprüfvorrichtung (100) nach Anspruch 4 bis 6, wobei das Mittel zum Positionieren ferner Mittel für eine Winkelbewegung der Haltemittel entlang einer Achse parallel zur Oberfläche des Prüfstücks (110) umfasst, um Winkelpositionen für die Mittel für die Mehrpunktsonde (102) bereitzustellen.

**8.** Mehrpunktprüfvorrichtung (100) nach Anspruch 4 bis 7, wobei das Mittel zum Positionieren ferner Mittel für eine Winkelbewegung der Haltemittel entlang einer Achse senkrecht zur Oberfläche des Prüfstücks (110) umfasst, um Winkelpositionen für die Mittel für die Mehrpunktsonde (102) bereitzustellen.

**9.** Mehrpunktprüfvorrichtung (100) nach Anspruch 4 bis 8, wobei das Mittel zum Positionieren ferner Mittel zum Abfühlen eines Kontakts zwischen dem Prüfstück (110) und der Mehrpunktsonde umfasst.

**10.** Mehrpunktprüfvorrichtung (100) nach Anspruch 1 bis 9, wobei das Nanoantriebsmittel eine Auflösung im Bereich von 1 nm bis 0.1 $\mu$m in allen räumlichen Richtungen aufweist.

**11.** Verfahren zum Prüfen von elektrischen Eigenschaften auf einer bestimmten Stelle eines Prüfstücks (110), umfassend:

a) Bereitstellen:

(i) einer Mehrpunktprüfvorrichtung (100) aufweisend:

Mittel (104) zum Aufnehmen und Tragen des Prüfstücks; und
Prüfmittel für elektrische Eigenschaften (106) umfassend Stromerzeugermittel zum Erzeugen eines Prüfsignals und elektrische Messmittel zum Erfassen eines Messsignals;

und
(ii) einer Mehrpunktsonde (102), umfassend:

einen Trägerkörper (12), der von einem Halbleiterscheibenkörper herrührt; und
eine erste Vielzahl von leitenden Sondenarmen (14a, 18a; 14b, 18b; 14c, 18c; 14d, 18d), die in einer koplanaren Beziehung zu einer Oberfläche (16) des Trägerkörpers positioniert sind und sich vom Trägerkörper (12) frei erstrecken, wodurch der ersten Vielzahl von leitenden Sondenarmen eine individuell flexible Bewegung verliehen wird (14a, 18a; 14b, 18b; 14c, 18c; 14d, 18d); und
wobei die leitenden Sondenarmen (14a, 18a; 14b, 18b; 14c, 18c; 14d, 18d) von einem Prozess zur Herstellung der Mehrpunktsonde (102) herrühren, der ein Erzeugen der leitenden Sondenarmen (14a, 18a; 14b, 18b; 14c, 18c; 14d, 18d) auf dem Halbleiterscheibenkörper in Gesichtskontakt mit dem Halbleiterscheibenkörper und Entfernen eines Teils des Halbleiterscheibenkörpers umfasst, um den Trägerkörper bereitzustellen und die leitenden Sondenarmen bereitzustellen (14a, 18a; 14b, 18b; 14c, 18c; 14d, 18d), die sich vom Trägerkörper (12) frei erstrecken;

b) Verbindungsaufnahme (114) durch die Mehrpunktsonde (102) mit den Prüfmitteln für elektrische Eigenschaften (106); und
c) Hin- und Herbewegen der Mehrpunktsonde (102) in Bezug auf das Prüfstück (110) durch Nanoantriebsmittel (1701, 1703, 1705, 1707), um zu bewirken, dass die leitenden Sondenarmen (14a, 18a; 14b, 18b; 14c, 18c; 14d, 18d) mit der bestimmten Stelle des Prüfstücks (110) in Kontakt kommen, um die Prüfung von elektrischen Eigenschaften davon durchzuführen.

**12.** Verfahren nach Anspruch 11, das die Mehrpunktsonde (102) in Bezug auf das Prüfstück (10) mit einer Auflösung im Bereich von 1 nm bis 0.1 $\mu$m in allen räumlichen Richtungen hin- und herbewegt.

## Revendications

**1.** Appareil de contrôle pour sonde à points multiples (100) servant à contrôler des propriétés électriques sur une position spécifique d'un échantillon d'essai (110), comprenant:

des moyens (104) pour recevoir et supporter ledit échantillon d'essai;

des moyens de contrôle de propriétés électriques (106) comportant des moyens générateurs pour générer un signal d'essai et des moyens de mesure électrique pour détecter un signal de mesure;

une sonde à points multiples (102) comprenant:

un corps de support (12) provenant d'un corps de tranche,
une première multitude de tiges de sonde conductrices (14a, 18a; 14b, 18b; 14c, 18c; 14d. 18d) positionnées en relation coplanaire avec une surface (16) dudit corps de support et qui s'étendent librement dudit corps de support (12), donnant un mouvement flexible de manière individuelle de ladite première multitude de tiges de sonde conductrices (14a, 18a; 14b, 18b; 14c, 18c; 14d. 18d); et
lesdites tiges de sonde conductrices (14a, 18a; 14b, 18b; 14c, 18c; 14d. 18d) provenant d'un processus de production de ladite sonde à points multiples (102) comportant la production desdites tiges de sonde conductrices (14a, 18a; 14b, 18b; 14c, 18c; 14d. 18d) sur ledit corps de tranche en contact facial avec ledit corps de tranche et, par élimination d'une partie dudit corps de tranche, à produire ledit corps de support et à produire lesdites tiges de sonde conductrices (14a, 18a; 14b, 18b; 14c, 18c; 14d. 18d) qui s'étendent librement à partir dudit corps de support (12);
ladite sonde à points multiples (102) communicant (114) avec lesdits moyens de contrôle de propriétés électriques (106); et
des moyens nano-actionneurs (1701, 1703, 1705, 1707) configurés pour effectuer un mouvement de va-et-vient de ladite sonde à points multiples (102) par rapport audit échantillon d'essai (110) de manière à provoquer lesdites tiges de sonde conductrices (14a, 18a; 14b, 18b; 14c, 18c; 14d. 18d) à entrer en contact avec ladite position spécifique dudit échantillon d'essai (110) pour effectuer ledit contrôle des propriétés électriques de ceux-ci.

2. Appareil de contrôle pour sonde à points multiples (100) selon la revendication 1, dans lequel lesdits moyens de contrôle de propriétés électriques (106) comprennent en outre des moyens de sondage de propriétés électriques dudit échantillon d'essai (110).

3. Appareil de contrôle pour sonde à points multiples (100) selon les revendications 1 et 2, dans lequel lesdits moyens nano-actionneurs (1701, 1703, 1705, 1707) comprennent en outre des moyens de maintien pour ladite sonde à points multiples (102).

4. Appareil de contrôle pour sonde à points multiples (100) selon la revendication 3, comprenant en outre des moyens de positionnement desdits moyens de maintien à travers ledit échantillon d'essai (110) et d'enregistrement d'une position desdits moyens de maintien par rapport audit échantillon d'essai (110).

5. Appareil de contrôle pour sonde à points multiples (100) selon la revendication 4, dans lequel lesdits moyens de positionnement comprennent des possibilités de manoeuvrer dans toutes les directions spacieuses, étant des directions coplanaire audit échantillon d'essai (110) et des directions perpendiculaires audit échantillon d'essai (110).

6. Appareil de contrôle pour sonde à points multiples (100) selon les revendications 4 à 5, dans lequel lesdits moyens de positionnement comprennent en outre des moyens de mouvement angulaire desdits moyens de maintien, de manière à pouvoir fournir des positions angulaires pour lesdits moyens pour ladite sonde à points multiples (102).

7. Appareil de contrôle pour sonde à points multiples (100) selon les revendications 4 à 6, dans lequel lesdits moyens de positionnement comprennent en outre des moyens de mouvement angulaire desdits moyens de maintien le long d'un axe parallèle à la surface dudit échantillon d'essai (110), de manière à fournir des positions angulaires pour ledit moyen de ladite sonde à points multiples (102).

8. Appareil de contrôle pour sonde à points multiples (100) selon les revendications 4 à 7, dans lequel lesdits moyens de positionnement comprennent en outre des moyens de mouvement angulaire desdits moyens de maintien le long d'un axe perpendiculaire à la surface dudit échantillon d'essai (110), de manière à fournir des positions angulaires pour ledit moyen de ladite sonde à points multiples (102).

9. Appareil de contrôle pour sonde à points multiples (100) selon les revendications 4 à 8, dans lequel lesdits moyens de positionnement comprennent en outre des moyens de percevoir du contact entre ledit échantillon d'essai (110) et ladite sonde à points multiples.

10. Appareil de contrôle pour sonde à points multiples (100) selon les revendications 1 à 9, dans lequel lesdits moyens nano-actionneurs ont une résolution dans la plage de 1 nm à 0.1 $\mu$m dans toutes les directions spacieuses.

11. Procédé de contrôle de propriétés électriques sur une position spécifique d'un échantillon d'essai (110) comprenant:

a) de fournir:

(i) un appareil de contrôle de sonde à points multiples (100) ayant:

des moyens (104) pour recevoir et supporter ledit échantillon d'essai; et des moyens de contrôle de propriétés électriques (106) comportant des moyens générateurs pour générer un signal d'essai et des moyens de mesure électrique pour détecter un signal de mesure;

et
(ii) une sonde à points multiples (102) comprenant:

un corps de support (12) provenant d'un corps de tranche; et une première multitude de tiges de sonde conductrices (14a, 18a; 14b, 18b; 14c, 18c; 14d. 18d) positionnées en relation coplanaire avec une surface (16) dudit corps de support et qui s'étendent librement dudit corps de support (12) en donnant un mouvement flexible de manière individuelle de ladite première multitude de tiges de sonde conductrices (14a, 18a; 14b, 18b; 14c, 18c; 14d. 18d); et

lesdites tiges de sonde conductrices (14a, 18a; 14b, 18b; 14c, 18c; 14d. 18d) provenant d'un processus de production de ladite sonde à points multiples (102) comportant la production desdites tiges de sonde conductrices (14a, 18a; 14b, 18b; 14c, 18c; 14d. 18d) sur ledit corps de tranche en contact facial avec ledit corps de tranche et, par élimination d'une partie dudit corps de tranche, à produire ledit corps de support et à produire lesdites tiges de sonde conductrices (14a, 18a; 14b, 18b; 14c, 18c; 14d. 18d) qui s'étendent librement à partir dudit corps de support (12) ;

b) de communiquer (114) ladite sonde à points multiples (102) avec lesdits moyens de contrôle de propriétés électriques (106); et
c) d'effectuer un mouvement de va-et-vient de ladite sonde à points multiples (102) par rapport audit échantillon d'essai (110) par moyen de moyens nano-actionneurs (1701, 1703, 1705, 1707) de manière à provoquer lesdites tiges de sonde conductrices (14a, 18a; 14b, 18b; 14c, 18c; 14d. 18d) à être mises en contact avec ladite position spécifique dudit échantillon d'essai (110) pour effectuer ledit contrôle des propriétés électriques de ceux-ci.

12. Procédé selon la revendication 11, effectuant un mouvement de va-et-vient de ladite sonde à points multiples (102) par rapport audit échantillon d'essai (110) ayant une résolution dans la plage de 1nm à 0.1$\mu$m dans toutes les directions spacieuses.

Current source    Electrometer

Sample

Tungsten tip

d

PRIOR ART

FIG. 1

V

I    I

Current lines

PRIOR ART

FIG. 2

**FIG. 3**

**FIG. 4**

**FIG. 5**

**FIG. 6**

FIG. 7

FIG. 8

FIG. 9

FIG. 10

Fig. 11

Fig. 12

Fig. 13

(A)             (B)             (C)

(D)             (E)             (F)

Fig. 14

Fig. 15

Fig. 16

PRIOR ART

FIG. 17

FIG. 18

FIG. 19

FIG. 20

FIG. 21

FIG. 22

FIG. 23

FIG. 24

FIG. 25

(a)

(b)

FIG. 26

**EP 1 698 905 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5229679 A
- US 5568004 A
- WO 9411745 A
- EP 0299875 B1
- US 5347226 A
- US 5475318 A
- US 5540958 A

- US 5557214 A
- EP 0466274 A
- EP 98610023 A
- DE 19648475
- JP 07199219 B
- JP 01147374 A
- JP H815318 B

**Non-patent literature cited in the description**

- **S.M. Sze.** Semiconductor devices - Physics and Technology. Wiley, 1985
- **F.M. Smits.** *Measurement of Sheet Resistivities with the Four-Point Probe, Bell System Technical J.,* 1958, vol. 37, 711
- **J. Shi ; Y. Sun.** New method for calculation of the correction factors for the measurement of sheet resistivity of a square sample with a square four-point probe. *Rev. Sci. Instrum.,* 1997, vol. 68, 1814
- **Soonil Hong et al.** design and fabrication of a monolithic high-density probe card for high-frequency on-wafer testing. IEEE, 1989, 289-292
- **Changyeol Lee et al.** high-density silicon microprobe arrays for LCD pixel inspection. IEEE, 1996, 429-434

- **T. Fujii et al.** micropattern measurement with an atomic force microscope. *Journal of Vacuum Science & Technology B,* 1991, 666
- **H.W.P. Koops et al.** Constructive three-dimensional lithography with electron beam induced deposition for quantum effect devices. *Journal of Vacuum Science & Technology B,* 1993, 2386
- **H.W. Koops et al.** conductive dots, wires, and supertips for field electron emitters produced by deposition on samples having increased temperature. *Journal of Vacuum Science & Technology B,* 1996, 6
- **Q. Niu et al.** double tip scanning tunnelling microscope for surface analysis. *Physics Rev. B,* 1995, 5502

32